# EUROPÄISCHE PATENTSCHRIFT

(11) **EP 3 597 020 B1**
(45) Veröffentlichungstag und Bekanntmachung des Hinweises auf die Patenterteilung: **09.08.2023**
(21) Anmeldenummer: 18713156.0
(22) Anmeldetag: 15.03.2018
(51) Int. Cl.: H05K 5/06, B29C 65/44

(54) **EXPLOSIONSGESCHÜTZTES GEHÄUSE UND VERFAHREN ZU DESSEN HERSTELLUNG**
EXPLOSION-PROOF HOUSING AND METHOD FOR PRODUCING SAME
BOÎTIER PROTÉGÉ CONTRE LES EXPLOSIONS ET PROCÉDÉ DE FABRICATION ASSOCIÉ

(30) Priorität: 16.03.2017 DE 102017105683
(43) Veröffentlichungstag der Anmeldung: 22.01.2020
(73) Patentinhaber: Eaton Intelligent Power Limited, Dublin 4 (IE)
(72) Erfinder: NAUMANN, Reiner, 68239 Mannheim (DE); BURMEISTER, Jens, 69412 Eberbach (DE); OTT, Toni, 69151 Neckargemünd (DE)
(74) Vertreter: Novagraaf Group
(86) Internationale Anmeldenummer: PCT/EP2018/056483
(87) Internationale Veröffentlichungsnummer: WO 2018/167195

(56) Entgegenhaltungen:
- DE-A1-102012 111 393
- DE-B3-102014 220 911
- US-A1- 2010 202 103

## Beschreibung

Die Erfindung betrifft ein explosionsgeschütztes Gehäuse aus zumindest einem metallischen Gehäuseteil mit wenigstens einer Gehäuseöffnung oder einer Aufnahmefläche und einem diese umrandenden Auflagerand. Weiterhin umfasst das Gehäuse ein die Gehäuseöffnung bzw. die Aufnahmefläche verschließendenes bzw. abdeckendes, insbesondere transparentes Deckelteil aus einem Kunststoff mit einem umlaufenden Deckelrand. Deckelrand und Auflagerand sind explosionsgeschützt miteinander verbunden, wobei insbesondere eine Ex-d-Verbindung gebildet wird. Durch ein solches explosionsgeschütztes Gehäuse sind auch in explosionsfähigen Atmosphären Zündungen dieser Atmosphäre durch in dem Gehäuse enthaltene elektrische oder elektronische Betriebsmittel verhindert.

Eine Möglichkeit in diesem Zusammenhang ist, beispielsweise ein Gehäuseteil mit einem Deckelteil mit entsprechenden Spalten zwischen diesen zu verbinden, wie ein Flachspalt, ein zylindrischer Spalt, oder ein Gewindespalt. Die entsprechende Spaltlänge und Spaltweite verhindert bei Zündung eines im Gehäuseinneren befindlichen Gemisches, dass eine außerhalb des Gehäuses befindliche ebenfalls explosionsgefährdete Atmosphäre gezündet wird.

Es gibt weitere Zündschutzarten, die ein solches Entzünden der äußeren Atmosphäre verhindern können, wie Sandkapselung, Vergußkapselung, Ölkapselung und dergleichen.

DE 10 2014 220911 B3 offenbart ein Gerät mit einem Gehäuse und mit wenigstens einer im Gehäuse untergebrachten elektrischen und/oder elektronischen Schaltung, wobei das Gehäuse ein Grundteil und ein Deckelteil aufweist, und das Grundteil oder Deckelteil ein Kunststoff-Bauteil und das andere der beiden Teile ein Metall-Bauteil ist, wobei das Metall-Bauteil einen Fügeabschnitt aufweist, der eine strukturierte Oberfläche aufweist, wobei das Kunststoff-Bauteil einen Gegenabschnitt aufweist, wobei der Gegenabschnitt mit der strukturierten Oberfläche unlösbar verzahnt ist, wobei die Verzahnung zwischen dem Fügeabschnitt und dem Gegenabschnitt Hinterschneidungen aufweist und mittels thermischem Aufschmelzen des Gegenabschnitts hergestellt ist.

Die vorliegende Erfindung betrifft insbesondere eine druckfeste Kapselung bei der in das entsprechende Gehäuse des elektrischen Betriebsmittel eine explosionsfähige Atmosphäre eindringen, aber bei einer Explosion innerhalb des Gehäuses ein Übertragen der Explosion auf die das Gehäuse umgebende explosionsfähige Atmosphäre verhindert wird. Dazu werden in der Regel die oben genannten Spalte verwendet, die so ausgeführt sind, dass eine Durchzündung durch diese Spalte sicher verhindert wird. Eine entsprechende Spaltgeometrie sowie Spaltlängen und Spaltweiten sind unterschiedlich ausgeführt, je nach Geräteschutzniveau.

Es ist ebenfalls aus der Praxis bekannt, insbesondere bei einem metallischen Gehäuseteil und einem Deckelteil aus Kunststoff, diese entlang der entsprechenden Ränder miteinander zu verkleben.

Der Erfindung liegt die Aufgabe zugrunde, ein Gehäuse der oben genannten Art dahingehend zu verbessern, dass klebemittelfrei eine entsprechende Verbindung von Gehäuseteil und Deckelteil zur Bildung eines explosionsgeschützten Gehäuses in einfacher und sicherer Weise durchgeführt werden kann. Gleichzeitig soll ein solches Gehäuse eine hohe Verbindungsstabilität zwischen Gehäuseteil und Deckelteil aufweisen, wobei die Verbindung, schnell und mit geringen Kosten herstellbar sein soll.

Diese Aufgabe wird durch die Merkmale des Patentanspruchs 1 bzw. die entsprechenden Verfahrensmerkmale nach Patentanspruch 11 gelöst.

Erfindungsgemäß ergeben sich eine Vielzahl von Verbindungsstellen zwischen Auflagerand und Deckelrand, die als ineinandergreifende Vertiefungen und Vorsprünge ausgebildet sind, wobei die Vorsprünge durch partielles Aufschmelzen des Deckelrandes gebildet sind. Dadurch ergeben sich zwischen Gehäuseteil und Deckelteil bzw. deren Rändern eine Anzahl von positiv verbundenen Verbindungsstellen, die je nach Erfordernis in entsprechender Anzahl und Form hergestellt werden können. Die Stabilität der Verbindung hängt dabei sowohl von den beiden Materialien, der Form und Anzahl der Verbindungsstellen als auch von deren Anordnung relativ zueinander ab. Ein solches explosionsgeschütztes Gehäuse nimmt elektrische Betriebsmittel auf, wobei durch das transparente Deckelteil die elektrischen Betriebsmittel und insbesondere Anzeigeleuchten oder dergleichen sichtbar sind. Diese Anzeigeleuchten können einen Status des elektrischen Betriebsmittels anzeigen. Dabei besteht weiterhin die Möglichkeit, das metallische Gehäuseteil zu öffnen, um die elektrischen Betriebsmittel zu warten oder dergleichen.

Die vorliegende Erfindung betrifft allerdings die Verbindung zwischen dem metallischen Gehäuseteil und dem Deckelteil.

Bezüglich der Vertiefungen im Auflagerand besteht die Möglichkeit, dass diese bei Herstellung des Gehäuseteils durch entsprechende maschinelle Bearbeitung hergestellt werden. Erfindungsgemäß ist es allerdings auch möglich, dass die Vertiefungen im Auflagerand des Gehäuseteils beispielsweise mittels eines Lasers oder dergleichen in entsprechender Anzahl und Form hergestellt werden. Anschließend kann direkt das Deckelteil aus Kunststoff durch Auflegen des Deckelrandes auf den Auflagerand aufgesetzt werden. Beispielsweise kann dann auch der Laser zum Erhitzen des Auflagerandes verwendet werden. Erfindungsgemäß schmilzt durch dieses Erhitzen der Deckelrand zumindest partiell und Material des Deckelrandes in die Vertiefungen hineinfließt unter Ausbildung der Vorsprünge. Anschließend erfolgt ein Aushärten des partiell geschmolzenen Deckelrandes zur klebemittelfreien Verbindung von Vertiefungen und den entsprechend gebildeten Vorsprüngen. Durch das Ineinandergreifen von Vertiefungen und Vorsprüngen erfolgt insgesamt die Verbindung zwischen metallischem Gehäuseteil und Deckelteil.

Dadurch wird ein geschlossenes Gehäuse aus zwei unterschiedlichen Komponenten gebildet, das die Anforderungen an den Explosionsschutz erfüllt. Das Gehäuse besteht aus dem metallischen Gehäuseteil und dem transparenten Deckelteil, die in einfacher, schneller und kostengünstiger Weise, ohne Verwendung eines Klebemittels verbunden werden.

Dabei besteht natürlich die Möglichkeit, Anzahl und Form der Vertiefungen sowie deren Abstand zueinander, deren Ausrichtung zum Auflagerand usw. bei der Herstellung zu bestimmen. Die entsprechenden Vorsprünge werden automatisch durch das entsprechende partielle Schmelzen des Deckelteils gebildet und es ergeben sich auf diese Weise eine Vielzahl von kleinen Verbindungsstellen, die bei hoher Verbindungsstabilität alle Anforderungen an den Explosionsschutz erfüllen. Weiterhin ergibt sich als Vorteil, dass die Verbindungsstabilität in keiner Weise mehr vom verwendeten Klebemittel oder dessen Wirkung abhängt, welches normalerweise ein einschränkendes Element für die Stabilität der Verbindung und für die Lebensdauer der Verbindung darstellt. Dies gilt insbesondere bei Temperaturänderungen und unterschiedlichen Ausdehnungen der verschiedenen Materialien des Gehäuses.

Bei einer Ausführungsform kann es sich als ausreichend erweisen, wenn die entsprechenden Vorsprünge und Vertiefungen sich im Wesentlichen nur in einer Richtung entlang der Ränder erstrecken. Es ist ebenfalls denkbar, dass sich die Vertiefungen und Vorsprünge in Richtung des jeweiligen umlaufenden Randes erstrecken und ggf. auch gekrümmt verlaufen. Alle diese verschiedenen Möglichkeiten sind je nach Erfordernis gemäß vorliegender Erfindung realisierbar und auch kombinierbar.

In einer Ausführungsform kann es sich als günstig erweisen, wenn alle Vertiefungen und Vorsprünge sich entlang nur einer Längsrichtung erstrecken, wobei diese insbesondere entlang einer Wandlängsrichtung oder Randlängsrichtung des Gehäuseteils verlaufen kann.

Die Vertiefungen könne sich beispielsweise einfach senkrecht zur Oberfläche des entsprechenden Auflagerandes nach unten in das Material erstrecken. Ebenfalls denkbar ist, dass die Vertiefungen senkrecht zur Längsrichtung schräg in das Material hinein verlaufen. Dies gilt jeweils analog für die Vorsprünge, die durch Aufschmelzen des Deckelrandes hergestellt werden und durch in die Vertiefungen eindringendes Material des Deckelteils gebildet sind.

Es sind andere Verläufe der Vertiefungen und damit der Vorsprünge denkbar, wie beispielsweise auch Vertiefungen und Vorsprünge, die im Wesentlichen senkrecht zur Längsrichtung verlaufende Nuten bzw. Nutvorsprünge aufweisen. Das heißt, die Vertiefungen erstrecken sich in das Material des Auflagerandes hinein, weisen aber in diesem noch senkrecht zur Längsrichtung verlaufende Nuten auf. Entsprechend werden die Vorsprünge ausgebildet.

In diesem Zusammenhang kann es weiterhin als vorteilhaft angesehen werden, wenn Nuten und Nutvorsprünge beidseitig senkrecht zur Längsrichtung ausgebildet sind. Dadurch ergibt sich eine innigere und stabilere Verbindung der entsprechenden Teile.

Bei einer Ausführungsform kann es weiterhin als vorteilhaft betrachtet werden, wenn beispielsweise eine entsprechende Anzahl von Vertiefungen und Vorsprüngen in Längsrichtung und senkrecht zur Längsrichtung beabstandet zueinander jeweils in den Rändern ausgebildet sind. So müssen sich die entsprechenden Vertiefungen nicht über die gesamte Länge des Auflagerandes erstrecken, sondern eine Anzahl solcher Vertiefungen können in Längsrichtung hintereinander und beabstandet zueinander ausgebildet werden. Dies gilt dann analog für die Vorsprünge im Deckelrand. Die Beabstandung kann auch in einer Richtung senkrecht zur Längsrichtung erfolgen, wobei in dieser Richtung jeweils so viele Vertiefungen und Vorsprünge gebildet werden, wie für eine sichere Verbindung zwischen Gehäuseteil und Deckelteil als notwendig erachtet werden.

Bei einer Ausführungsform ist der Auflagerand bzw. Deckelrand jeweils für sich aus Metall und Kunststoff gebildet. Dabei besteht die Möglichkeit, dass jeweils im metallischen Teil die Vertiefungen und im Kunststoffteil die Vorsprünge gebildet werden. In einer nicht beanspruchten Ausführungsform sind die entsprechenden Teile allerdings jeweils aus nur einer Komponente zumindest im Bereich ihrer Ränder hergestellt, so dass die Vertiefungen im Auflagerand und die Vorsprünge im Deckelrand ausgebildet sind. Um ggf. unterschiedliche Temperaturausdehnungen dieser Materialien kompensieren zu können, greifen Vertiefungen und Vorsprünge in Längsrichtung mit Spiel ineinander.

Bei einer Ausführungsform können Vertiefungen und Vorsprünge mit jeweils gleicher Länge in Längsrichtung und gleichem Abstand angeordnet sein. Ebenfalls ist es denkbar, dass Vertiefungen und Vorsprünge alle mit gleicher Form ausgebildet sind. Dabei ergibt sich die Form der Vorsprünge im Wesentlichen durch die Form der Vertiefungen, siehe das erfindungsgemäße Verfahren.

Die Erfindung kann ebenfalls dann verwendet werden, wenn beispielsweise das Gehäuseteil ein Kühlkörper und das Deckelteil eine Plastikabdeckung für eine lichtemittierende Diode (LED) ist. Dabei kann eine entsprechende Plastikabdeckung auch für mehrere LEDs vorgesehen sein. Die LED bzw. LEDs ist/sind beabstandet voneinander auf dem Kühlkörper und dessen Aufnahmefläche angeordnet, wobei diese Aufnahmefläche von dem Auflagerand umgeben wird. Im Bereich dieses Auflagerands liegt dann die entsprechende Plastikabdeckung für eine oder mehrere LEDs mit dem entsprechenden Deckelrand auf dem Auflagerand auf und wird dort in der bereits beschriebenen Weise befestigt.

Die oben erwähnten Nuten bzw. Nutvorsprünge ergeben sich erfindungsgemäß dadurch, dass sie im Schritt der Herstellung der entsprechenden Vertiefung durch einen Hinterschnitt im Bereich des Vertiefungsbodens hergestellt werden. Dieser Hinterschnitt bildet dann je nach seiner Anordnung eine oder auch zwei Nuten. Der entsprechende Nutvorsprung ergibt sich beim Aufschmelzen des Deckelrandes zur Herstellung des Vorsprungs, der dann die entsprechenden Nutvorsprünge zusätzlich aufweist.

Dies gilt ebenfalls bei der Herstellung von schräg zur Längsrichtung verlaufenden Vertiefungen, die ebenfalls in entsprechender Weise direkt durch den Laser oder auch eine andere Bearbeitungsweise bei der Herstellung der Vertiefungen im Auflagerand hergestellt werden.

Im Folgenden werden vorteilhafte Ausführungsformen der Erfindung anhand der in Zeichnung beigefügten Figuren näher erläutert. Es zeigen:
- Figur 1: eine perspektivische Draufsicht von oben auf ein erfindungsgemäßes explosionsgeschütztes Gehäuse aus Gehäuseteil und Deckelteil;
- Figur 2: einen Schnitt entlang einer Linie A-A aus Fig. 4 bei einem ersten Ausführungsform;
- Figur 3: einen Schnitt analog zu Fig. 2 durch ein zweites Ausführungsform;
- Figur 4: einen Blick auf einen Bereich X aus Fig. 1 in vergrößerter Darstellung;
- Figur 5: einen Blick auf einen Bereich Y aus Fig. 1 in vergrößerter Darstellung für ein weiteres Ausführungsform; und
- Figur 6: einen Schnitt analog zu Fig. 2 und 3 entlang einer Linie B-B senkrecht zur Linie A-A.

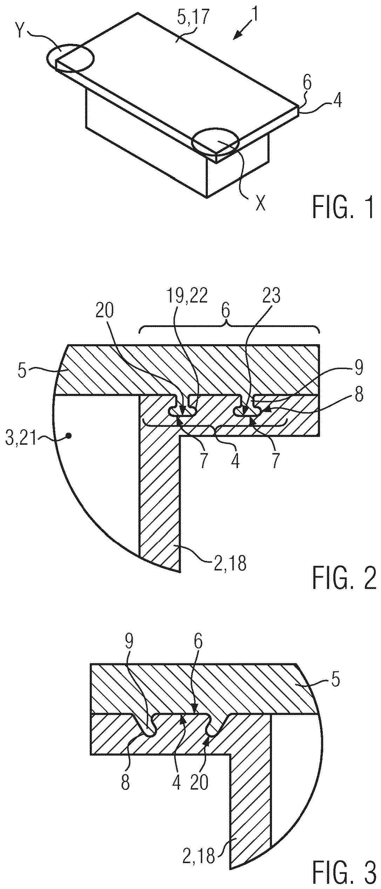

Fig. 1 zeigt ein erfindungsgemäßes explosionsgeschütztes Gehäuse 1, bestehend aus einem Gehäuseteil 2 und einem Deckelteil 5. Ein solches Gehäuseteil 2 kann ebenfalls ein Kühlkörper 16 sein, auf dem beispielsweise eine oder mehrere LEDs angeordnet sind, die durch eine Plastikabdeckung 17 anstelle eines ebenen Deckelteils 5 abgedeckt sind. In jedem Fall weist das explosionsgeschützte Gehäuse bzw. Gehäuseteil 2 oder Deckelteil 5 einen entsprechenden Auflagerand 4 bzw. Deckelrand 6 auf, siehe auch die Fig. 2 und 3. Diese sind miteinander in Anlage und durch eine Vielzahl von Verbindungsstellen 7 verbunden. Das Gehäuseteil 2 besteht aus Metall und das Deckelteil 5 aus einem transparenten Kunststoff. Dadurch sind elektrische Betriebsmittel wie beispielsweise eine Signalleuchte oder dergleichen innerhalb des Gehäuseteils 2 sichtbar oder, bei Kühlkörper 16 und Plastikabdeckung 17, sind die entsprechenden LEDs sichtbar.

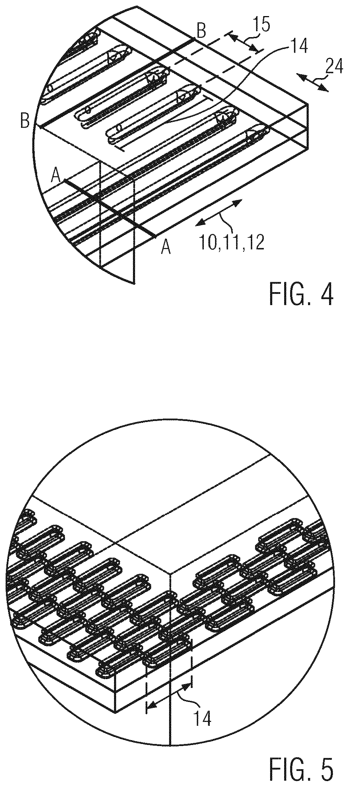

In Fig. 2 und 3 sind Längsschnitte entlang der Linie A-A aus Fig. 4 dargestellt für zwei unterschiedliche Ausführungsbeispiele der Verbindungsstellen 7.

In Fig. 2 erstrecken sich Vertiefungen 8 entlang einer Richtung 10, siehe Fig. 4, die bei dem dargestellten Ausführungsform einer Längsrichtung 11 bzw. einer Richtung parallel zur Wandlängsrichtung 12 einer entsprechenden Gehäusewand 18 entspricht.

Es ist ebenfalls möglich, dass sich die Vertiefungen 8 nicht nur in eine Richtung erstrecken, sondern je nach Anordnung im Auflagerand 4 in unterschiedlichen Richtungen erstrecken oder auch im Bereich von Ecken des Auflagerandes 4 gekrümmt oder winklig verlaufen. Allerdings ist eine Herstellung von Vertiefungen 8, die alle in der gleichen Längsrichtung 11, und im Wesentlichen parallel zur Wandlängsrichtung 12 verlaufen, ein einfaches Ausführungsform, das sich durch eine einfache Anordnung der entsprechenden Vertiefungen auszeichnet.

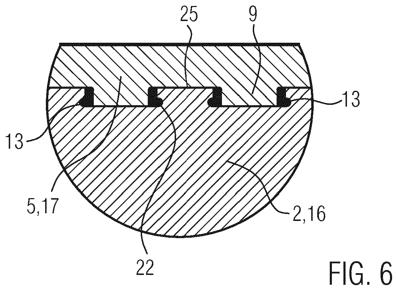

In Fig. 2 weisen die Vertiefungen im Bereich eines Vertiefungsbodens 20, siehe auch Fig. 3, einen Hinterschnitt 19 in Form von Nuten 22 auf. Diese erstrecken sich beidseitig zur Längsrichtung 11 in entsprechender Querrichtung 24, siehe auch Fig. 4. In Längsrichtung 11 sind die Nuten 22 durch entsprechende Nutvorsprünge 23 der Vorsprünge 9 gefüllt, während entsprechende Nuten, siehe Fig. 6, an Enden der Vertiefungen 8 in Längsrichtung 11 ungefüllt sind zur Herstellung eines Spiels 13 zwischen Vertiefungen 8 und Vorsprüngen 9. Dadurch sind mögliche unterschiedliche Ausdehnungen von Gehäuseteil 2 und Deckelteil 5 bei wechselnden Temperaturen aufgrund der unterschiedlichen Materialien ausgleichbar.

Bei dem Ausführungsform nach Fig. 2 sind zwei Vertiefungen 8 im entsprechenden Auflagerand 4 nebeneinander in Querrichtung 24 angeordnet, siehe auch Fig. 4. Es besteht natürlich die Möglichkeit, auch weniger oder mehr solcher Vertiefungen mit unterschiedlichen Abständen, Tiefen und Formen herzustellen. Bei einem Ausführungsform sind die Vertiefungen 8 alle von gleicher Form und je nach Anordnung im Auflagerand auch von gleicher Länge 14, siehe Fig. 4 und 5.

Das Gehäuseteil 2 weist in Fig. 2 eine Gehäuseöffnung 3 auf, die durch das Deckelteil 5 nach oben verschlossen ist. Anstelle der Gehäuseöffnung 3 kann eine Aufnahmefläche 21 ausgebildet sein, die beispielsweise zur Anordnung einer oder mehrere LEDs auf einem entsprechenden Kühlkörper 16 als Gehäuseteil 2 dient.

In Fig. 3 ist ein anderes Ausführungsform der Vertiefungen 8 dargestellt, in die die entsprechenden Vorsprünge 9 hineingreifen. In diesem Fall verlaufen die Vertiefungen 8 in Querrichtung 24, d. h. senkrecht zur Längsrichtung 11, schräg in Richtung zur Gehäusewand 18 bzw. auch weg von dieser Gehäusewand. Auch in diesem Fall besteht die Möglichkeit, dass alle Vertiefungen 8 in gleicher Weise schräg verlaufen oder, siehe Fig. 3, jeweils schräg aufeinander zu verlaufen. Auch bei diesen schräg verlaufenden Vertiefungen 8 besteht die Möglichkeit, zusätzlich entsprechende Nuten 22, siehe Fig. 2, auszubilden.

Die Vertiefungen 8 sind in Querrichtung 24 im Wesentlichen von den Vorsprüngen 9 ausgefüllt, wobei dies ebenfalls für die Nuten 22 gilt, in die die Nutvorsprünge 23 der Vorsprünge 9 eingreifen. An Enden der Vertiefungen 8 in Längsrichtung 11, siehe Fig. 6, ist ein Spiel 13 zwischen Vorsprüngen 9 und Vertiefungen 8 zur Längenkompensation bei unterschiedlichen Temperaturen (siehe die obigen Ausführungen) vorhanden.

Weiterhin besteht die Möglichkeit, dass die Nuten 22 nicht direkt am Vertiefungsboden 20 ausgebildet sind, siehe Fig. 2, sondern beispielsweise beabstandet zum Vertiefungsboden angeordnet sind.

In Fig. 4 und 5 sind unterschiedliche Verteilungen von Vertiefungen 8 und damit von Vorsprüngen 9 dargestellt.

In Fig. 4 verlaufen die Vertiefungen 8 alle in Längsrichtung 11 bzw. parallel zur Wandlängsrichtung 12. Zwei Vertiefungen 8 entlang von längeren Kanten des Gehäuseteils 2 bzw. des Auflagerandes 4 erstrecken sich im Wesentlichen über die gesamte Länge, während entlang der Querrichtung 15 kürzere Vertiefungen 8 angeordnet sind, die sich allerdings auch im Wesentlichen über nahezu die gesamte Länge von Auflagerand bzw. Deckelrand erstrecken. Ein entsprechender Abstand 15 zwischen allen Vertiefungen 8 kann konstant sein, wobei allerdings die Länge 14 der Nuten entlang der kürzeren Teile des Auflagerandes kürzer als die Längen der anderen Vertiefungen 8 sind.

In Fig. 5 sind sowohl die Abstände als auch die Längen 14 aller Vertiefungen 8 im Wesentlichen gleich. Dies gilt ebenso für die Form und Tiefe der entsprechenden Vertiefungen 8.

Weitere Anordnungen der Vertiefungen 8 sind möglich, so dass beispielsweise bei drei Reihen von Vertiefungen 8 nach Fig. 5 nebeneinander auch Vertiefungen mit unterschiedlichen Längen (beispielsweise auch eine oder zwei Vertiefungen analog zu Fig. 4) ausgebildet sein können.

Die Anordnungen der verschiedenen Vertiefungen 8 gelten für alle Ausführungsformen der Vertiefungen, siehe insbesondere Fig. 2 und 3.

Nach dem erfindungsgemäßen Verfahren werden diese Vertiefungen 8 direkt in der Oberfläche des Auflagerandes 4, beispielsweise durch einen Laser, hergestellt. Dabei erfolgt die Herstellung der Vertiefungen in entsprechender Anzahl, Länge und Anordnung je nach Erfordernis und wie vom Hersteller gewünscht. Anschließend wird das Deckelteil bzw. die Plastikabdeckung auf Gehäuseteil 2 bzw. Kühlkörper 16 aufgelegt, wobei Auflagerand 4 und Deckelrand 6 miteinander in Anlage sind. Durch Erhitzen des Auflagerandes 4, beispielsweise wiederum durch den Laser, schmilzt der Deckelrand partiell und Material des Deckelrandes fließt in die Vertiefungen 8, um diese aufzufüllen. Dadurch ergeben sich die Vorsprünge 9, ggf. mit Nutvorsprüngen 23, siehe Fig. 2 und 3. Erfindungsgemäß füllen an Enden der Vertiefungen 8 in Längsrichtung 11 die Vertiefungen nicht vollständig durch die jeweiligen Vorsprünge 9, wodurch sich nach Fig. 6 das enstprechende Spiel 13 ergibt.

Fig. 6 entspricht dabei einem Schnitt entlang der Längsrichtung 11 durch die Vertiefungen mit Vorsprüngen nach Fig. 5 und Zwischenräume 25 zwischen benachbarten Vertiefungen/Vorsprüngen.

Erfindungsgemäß ergibt sich in einfacher, schneller und preiswerter Weise eine Verbindung zwischen einem Gehäuseteil und einem Deckelteil zur Herstellung eines explosionsgeschützten Gehäuses. Die Verbindung erfolgt an einer Vielzahl von Verbindungsstellen ohne Verwendung eines Klebemittels. Die hergestellte Verbindung weist eine hohe Stabilität und eine lange Lebensdauer auf. Gleichzeitig ist durch ein nicht vollständiges Füllen der Vertiefungen durch die Vorsprünge ein Längenausgleich zwischen den Materialien bei sich verändernden Temperaturen möglich.

Es wird insbesondere eine Ex-d-Verbindung hergestellt, die je nach Erfordernis mit mehr oder weniger Vertiefungen und Vorsprüngen in entsprechender Anordnung realisiert wird.

Die vorliegende Erfindung kann für alle Fälle eingesetzt werden, in denen elektrische Betriebsmittel in oder an einem Metallteil befestigt und durch ein Deckelteil oder eine Abdeckung aus Kunststoff abgedeckt werden.

## Patentansprüche

1. Explosionsgeschütztes Gehäuse (1) aus zumindest einem metallischen Gehäuseteil (2) mit wenigstens einer Gehäuseöffnung (3) oder Aufnahmefläche (21) und einem diese umrandenden Auflagerand (4) sowie einem die Gehäuseöffnung (3) bzw. Aufnahmefläche (21) abdeckenden Deckelteil aus Kunststoff mit einem umlaufenden Deckelrand, der mit dem Auflagerand (4) explosionsgeschützt verbunden ist, damit bei einer Explosion innerhalb des Gehäuses (1) ein Übertragen der Explosion auf eine das Gehäuse umgebende explosionsfähige Atmosphäre verhindert wird,
eine Vielzahl von Verbindungsstellen (7) zwischen Auflagerand (4) und Deckelrand (6) als ineinandergreifende Vertiefungen (8) und Vorsprünge (9) ausgebildet sind, wobei die Vorsprünge (9) durch partielles Aufschmelzen des Deckelrandes (6) gebildet sind,
**dadurch gekennzeichnet, dass**
die Vertiefungen (8) und Vorsprünge (9) in einer Längsrichtung (11) mit Spiel (13) ineinandergreifen, wobei die Längsrichtung (11) entlang einer Wandlängsrichtung (12) einer entsprechenden Gehäusewand (18) oder Auflagerandlängsrichtung des Gehäuseteils (2) verlauft.

2. Explosionsgeschütztes Gehäuse nach Anspruch 1, **dadurch gekennzeichnet, dass** Vertiefungen (8) und Vorsprünge (9) jeweils voneinander beabstandet in zumindest einer Richtung entlang des Auflagerands (4) bzw. Deckelrands (6) gebildet sind und sich insbesondere alle Vertiefungen (8) und Vorsprünge (9) entlang nur einer Längsrichtung (11), insbesondere parallel zu einer Wandlängsrichtung (12) des Gehäuses (1) erstrecken.

3. Explosionsgeschütztes Gehäuse nach Ansprüche 1 oder 2, **dadurch gekennzeichnet, dass** Vertiefungen (8) und Vorsprünge (9) senkrecht zur Längsrichtung (11) schräg verlaufen.

4. Explosionsgeschütztes Gehäuse nach einem der vorangehenden Ansprüche, **dadurch gekennzeichnet, dass** Vertiefungen (8) und Vorsprünge (9) im Wesentlichen senkrecht zur Längsrichtung (11) verlaufende Nuten (22) bzw. Nutvorsprünge (23) aufweisen.

5. Explosionsgeschütztes Gehäuse nach einem der vorangehenden Ansprüche, **dadurch gekennzeichnet, dass** Nuten (22) und Nutvorsprünge (23) beidseitig in den Vertiefungen (8) bzw. an den Vorsprüngen (9) im Wesentlichen senkrecht zur Längsrichtung (11) ausgebildet sind.

6. Explosionsgeschütztes Gehäuse nach einem der vorangehenden Ansprüche, **dadurch gekennzeichnet, dass** eine Anzahl von Vertiefungen (8) und Vorsprüngen (9) in Längsrichtung (11) und senkrecht zur Längsrichtung beabstandet voneinander an den Rändern (4, 6) ausgebildet sind.

7. Explosionsgeschütztes Gehäuse nach einem der vorangehenden Ansprüche, **dadurch gekennzeichnet, dass** die Vertiefungen (8) jeweils im Auflagerand (4) und die Vorsprünge (9) jeweils im Deckelrand (6) ausgebildet sind.

8. Explosionsgeschütztes Gehäuse nach einem der vorangehenden Ansprüche, **dadurch gekennzeichnet, dass** die Vertiefungen (8) oder Vorsprünge (9) mit jeweils gleicher Länge (14) in Längsrichtung (11) und/oder gleichem Abstand (15) angeordnet sind.

9. Explosionsgeschütztes Gehäuse nach einem der vorangehenden Ansprüche, **dadurch gekennzeichnet, dass** Vertiefungen (8) oder Vorsprünge (9) mit jeweils gleicher Form ausgebildet sind.

10. Explosionsgeschütztes Gehäuse nach einem der vorangehenden Ansprüche, **dadurch gekennzeichnet, dass** das Gehäuseteil (2), ein Kühlkörper (16) und das Deckelteil (5) eine Kunststoffabdeckung (17) für wenigstens eine lichtemittierende Diode (LED) ist.

11. Verfahren zur Verbindung eines metallischen Gehäuseteils (2) und eines Deckelteils (5) aus Kunststoff eines explosionsgeschützten Gehäuses (1), wobei bei einer Explosion innerhalb des Gehäuses (1) ein Übertragen der Explosion auf eine das Gehäuse umgebende explosionsfähige Atmosphäre verhindert wird, **gekennzeichnet durch** die folgenden Schritte:
i) Herstellen von Vertiefungen (8) in einem Auflagerand (4) des Gehäuseteils (2);
ii) Aufsetzen des Deckelteils (5) aus Kunststoff durch Auflegen eines Deckelrandes (6) auf den Auflagerand (4);
iii) Erhitzen zumindest des Auflagerandes (4) bis zum partiellen Schmelzen des Deckelrandes (6) und dessen Fließen in die Vertiefungen (8) unter Ausbildung von Vorsprüngen (9), wobei ein Aufschmelzen des Deckelrandes (6) so erfolgt, dass die Vorsprünge (9) senkrecht zur Längsrichtung die Vertiefungen (8) im Wesentlichen ausfüllen und in Längsrichtung (11) ein Spiel (13) zwischen Vorsprüngen (9) und Vertiefungen (8) verbleit, wobei die Längsrichtung (11) entlang einer Wandlängsrichtung (12) einer entsprechenden Gehäusewand (18) oder Auflagerandlängsrichtung des Gehäuseteils (2) verlauft;
iv) Aushärten des partiell geschmolzenen Deckelrandes (6) zur klebemittelfreien Verbindung von Gehäuseteil (2) und Deckelteil (5) mittels ineinandergreifender Vorsprünge und Vertiefungen.

12. Verfahren nach Anspruch 11, wobei im Schritt i) die Vertiefungen (8) entlang einer Längsrichtung (11) gebildet werden, die sich im Wesentlichen parallel zu einer Gehäusewand (18) erstreckt.

13. Verfahren nach Anspruch 10 oder 11, wobei im Schritt i) die Vertiefungen (8) mit einem Hinterschnitt (19) insbesondere am Vertiefungsboden (20) hergestellt werden.

14. Verfahren nach einem der vorangehenden Ansprüche 10 bis 12, wobei im Schritt i) die Vertiefungen (8) in einer senkrecht zur Längsrichtung (11) laufenden Querrichtung (24) schräg verlaufen.

## Claims

1. Explosion-proof housing (1) consisting of at least one metal housing part (2) having at least one housing opening (3) or receiving surface (21) and a support edge (4) which borders the at least one housing opening or receiving surface, and a cover part made of plastics material which covers the housing opening (3) or receiving surface (21) and has a peripheral cover edge which is connected in an explosion-proof manner to the support edge (4) so that, in the case of an explosion within the housing (1), a transfer of the explosion to an explosive atmosphere surrounding the housing is prevented,
a plurality of connection points (7) is formed between the support edge (4) and the cover edge (6) as interlocking depressions (8) and protrusions (9), the protrusions (9) being formed by partial melting of the cover edge (6), **characterized in that**
the depressions (8) and protrusions (9) interlock in a longitudinal direction (11) with clearance (13), the longitudinal direction (11) extending along a wall longitudinal direction (12) of a corresponding housing wall (18) or support edge longitudinal direction of the housing part (2).

2. Explosion-proof housing according to claim 1, **characterized in that** depressions (8) and protrusions (9) are each formed at a distance from one another in at least one direction along the support edge (4) or cover edge (6), and in particular all depressions (8) and protrusions (9) extend in only one longitudinal direction (11), in particular in parallel with a wall longitudinal direction (12) of the housing (1).

3. Explosion-proof housing according to either claim 1 or claim 2, **characterized in that** depressions (8) and protrusions (9) extend obliquely orthogonally to the longitudinal direction (11).

4. Explosion-proof housing according to any of the preceding claims, **characterized in that** depressions (8) and protrusions (9) have grooves (22) or groove protrusions (23) extending substantially orthogonally to the longitudinal direction (11).

5. Explosion-proof housing according to any of the preceding claims, **characterized in that** grooves (22) and groove protrusions (23) are formed substantially orthogonally to the longitudinal direction (11) on both sides in the depressions (8) or on the protrusions (9).

6. Explosion-proof housing according to any of the preceding claims, **characterized in that** a number of depressions (8) and protrusions (9) is formed at a distance from each other at the edges (4, 6) in the longitudinal direction (11) and orthogonally to the longitudinal direction.

7. Explosion-proof housing according to any of the preceding claims, **characterized in that** the depressions (8) are each formed in the support edge (4) and the protrusions (9) are each formed in the cover edge (6).

8. Explosion-proof housing according to any of the preceding claims, **characterized in that** the depressions (8) or protrusions (9) each having the same length (14) are arranged in the longitudinal direction (11) and/or at the same distance (15).

9. Explosion-proof housing according to any of the preceding claims, **characterized in that** depressions (8) or protrusions (9) are in each case formed with the same shape.

10. Explosion-proof housing according to any of the preceding claims, **characterized in that** the housing part (2), a heat sink (16) and the cover part (5) is a plastics cover (17) for at least one light-emitting diode (LED).

11. Method for connecting a metal housing part (2) and a cover part (5) made of plastics material of an explosion-proof housing (1), and in the case of an explosion within the housing (1), a transfer of the explosion to an explosive atmosphere surrounding the housing is prevented, **characterized by** the following steps:
i) creating depressions (8) in a support edge (4) of the housing part (2);
ii) fitting the cover part (5) made of plastics material by placing a cover edge (6) onto the support edge (4);
iii) heating at least the support edge (4) until the partial melting of the cover edge (6) and the flow thereof into the depressions (8) to form protrusions (9), melting of the cover edge (6) taking place in such a way that the protrusions (9) substantially fill the depressions (8) orthogonally to the longitudinal direction and a clearance (13) remains between protrusions (9) and depressions (8) in the longitudinal direction (11), the longitudinal direction (11) extending in a wall longitudinal direction (12) of a corresponding housing wall (18) or support edge longitudinal direction of the housing part (2);
iv) curing the partially melted cover edge (6) to effect the adhesive-free connection of the housing part (2) and cover part (5) by means of interlocking protrusions and depressions.

12. Method according to claim 11, wherein in step i), the depressions (8) are formed in a longitudinal direction (11) which extends substantially in parallel with a housing wall (18).

13. Method according to either claim 10 or claim 11, wherein in step i), the depressions (8) are produced with an undercut (19) in particular at the depression bottom (20).

14. Method according to any of the preceding claims 10 to 12, wherein in step i), the depressions (8) extend obliquely in a transverse direction (24) running orthogonally to the longitudinal direction (11).

## Revendications

1. Boîtier antidéflagrant (1) constitué d'au moins une partie de boîtier métallique (2) comportant au moins une ouverture de boîtier (3) ou surface de réception (21) et un bord d'appui (4) qui l'entoure, ainsi qu'une partie de couvercle en plastique, qui recouvre l'ouverture de boîtier (3) ou la surface de réception (21), comportant un bord de couvercle circonférentiel, qui est relié au bord d'appui (4) de manière protégée contre les explosions, afin d'éviter, en cas d'explosion à l'intérieur du boîtier (1), une transmission de l'explosion à une atmosphère explosive entourant le boîtier,
une pluralité de points de liaison (7) sont conçues entre le bord d'appui (4) et le bord de couvercle (6) en tant que creux (8) et saillies (9) qui s'imbriquent les uns dans les autres, dans lequel les saillies (9) sont formées par fusion partielle du bord de couvercle (6), **caractérisé en ce que**
les creux (8) et saillies (9) s'imbriquent les uns dans les autres dans une direction longitudinale (11) avec jeu (13), dans lequel la direction longitudinale (11) s'étend le long d'une direction longitudinale de paroi (12) d'une paroi de boîtier (18) correspondante ou une direction longitudinale de bord d'appui de la partie de boîtier (2).

2. Boîtier antidéflagrant selon la revendication 1, **caractérisé en ce que** des creux (8) et des saillies (9) sont formés respectivement espacés les uns des autres dans au moins une direction le long du bord d'appui (4) ou du bord de couvercle (6) et en particulier tous les creux (8) et toutes les saillies (9) s'étendent le long uniquement d'une direction longitudinale (11), en particulier parallèlement à une direction longitudinale de paroi (12) du boîtier (1).

3. Boîtier antidéflagrant selon les revendications 1 ou 2,
**caractérisé en ce que** les creux (8) et saillies (9) s'étendent à l'oblique perpendiculairement à la direction longitudinale (11).

4. Boîtier antidéflagrant selon l'une quelconque des revendications précédentes, **caractérisé en ce que** les creux (8) et saillies (9) présentent des rainures (22) ou saillies de rainure (23) s'étendant essentiellement perpendiculairement à la direction longitudinale (11).

5. Boîtier antidéflagrant selon l'une quelconque des revendications précédentes, **caractérisé en ce que** les rainures (22) et saillies de rainure (23) sont formées des deux côtés dans les creux (8) respectivement sur les saillies (9) essentiellement perpendiculairement à la direction longitudinale (11).

6. Boîtier antidéflagrant selon l'une quelconque des revendications précédentes, **caractérisé en ce qu'**un nombre de creux (8) et de saillies (9) sont formés espacés les uns des autres dans la direction longitudinale (11) et perpendiculairement à la direction longitudinale au niveau des bords (4, 6).

7. Boîtier antidéflagrant selon l'une quelconque des revendications précédentes, **caractérisé en ce que** les creux (8) sont formés respectivement dans le bord d'appui (4) et les saillies (9) respectivement dans le bord de couvercle (6).

8. Boîtier antidéflagrant selon l'une quelconque des revendications précédentes, **caractérisé en ce que** les creux (8) ou les saillies (9) sont agencés avec respectivement une longueur identique (14) dans la direction longitudinale (11) et/ou une distance identique (15).

9. Boîtier antidéflagrant selon l'une quelconque des revendications précédentes, **caractérisé en ce que** les creux (8) ou saillies (9) sont formés respectivement avec une forme identique.

10. Boîtier antidéflagrant selon l'une quelconque des revendications précédentes, **caractérisé en ce que** la partie de boîtier (2), est un dissipateur thermique (16) et la partie de couvercle (5) est un recouvrement en plastique (17) pour au moins une diode électroluminescente (LED).

11. Procédé de liaison d'une partie de boîtier métallique (2) et d'une partie de couvercle (5) en plastique d'un boîtier antidéflagrant (1), dans lequel, en cas d'explosion à l'intérieur du boîtier (1), une transmission de l'explosion à une atmosphère explosive entourant le boîtier est évitée, **caractérisé par** les étapes suivantes :
i) fabrication de creux (8) dans un bord d'appui (4) de la partie de boîtier (2) ;
ii) mise en place de la partie de couvercle (5) en plastique par l'accrochage d'un bord de couvercle (6) sur le bord d'appui (4) ;
iii) chauffage d'au moins le bord d'appui (4) jusqu'à une fusion partielle du bord de couvercle (6) et son écoulement dans les creux (8) en formant des saillies (9), dans lequel une fusion du bord de couvercle (6) est effectuée de telle sorte que les saillies (9) remplissent essentiellement les creux (8) perpendiculairement à la direction longitudinale et, dans la direction longitudinale (11), un jeu (13) reste entre les saillies (9) et les creux (8), dans lequel la direction longitudinale (11) s'étend le long d'une direction longitudinale de paroi (12) d'une paroi de boîtier (18) correspondante ou une direction longitudinale de bord d'appui de la partie de boîtier (2) ;
iv) durcissement du bord de couvercle (6) partiellement fondu pour la liaison sans adhésif de la partie de boîtier (2) et de la partie de couvercle (5) au moyen des saillies et creux s'imbriquant les uns dans les autres.

12. Procédé selon la revendication 11, dans lequel dans l'étape i), les creux (8) sont formés le long d'une direction longitudinale (11), qui s'étend essentiellement parallèlement à une paroi de boîtier (18).

13. Procédé selon la revendication 10 ou 11, dans lequel dans l'étape i), les creux (8) sont fabriqués avec une contre-dépouille (19) en particulier au niveau du fond de creux (20).

14. Procédé selon l'une des revendications précédentes 10 à 12, dans lequel dans l'étape i), les creux (8) s'étendent à l'oblique dans une direction transversale (24) perpendiculaire à la direction longitudinale (11).
